# EUROPEAN PATENT SPECIFICATION

(11) **EP 0 812 475 B1**
(45) Date of publication and mention of the grant of the patent: **21.11.2001**
(21) Application number: 96938424.7
(22) Date of filing: 03.12.1996
(51) Int. Cl.: H01L 27/06, H01L 29/73, H01L 29/78, H01L 21/8249, H01L 21/469

(54) **Method of manufacturing a semiconductor device comprising a silicon body with bipolar and MOS transistors**
Verfahren zur Herstellung eines Halbleiterbauteils auf Siliziumsubstrat mit Bipolartransistoren und MOS-Transistoren
Procédé de formation d'un semiconducteur comportant un corps de silicium avec les transistors MOS et les transistors bipolaires

(30) Priority: 21.12.1995 EP 95203585
(43) Date of publication of application: 17.12.1997
(73) Proprietor: Koninklijke Philips Electronics N.V., 5621 BA Eindhoven (NL)
(72) Inventor: KOSTER, Ronald, NL-5656 AA Eindhoven (NL); EMONS, Catharina, Huberta, Henrica, NL-5656 AA Eindhoven (NL)
(74) Representative: Rensen, Jan Geert
(86) International application number: IB9601340
(87) International publication number: WO9723908

(56) References cited:
- EP-A- 0 500 233
- US-A- 4 044 452
- US-A- 4 746 963
- US-A- 4 884 117
- PATENT ABSTRACTS OF JAPAN, Vol. 96, No. 2; & JP,A,07 263 539 (HITACHI LTD), 13 October 1995.

## Description

The invention relates to a method of manufacturing a semiconductor device comprising a silicon body with a surface which is adjoined by insulation regions of a first and a second type, the insulation regions of the first type enclosing active regions each with a bipolar transistor and the insulation regions of the second type enclosing active regions each with an MOS transistor.

The silicon body may comprise bipolar transistors both of the npn type and of the pnp type, as well as MOS transistors of the n-channel type and MOS transistors of the p-channel type here. A semiconductor device which comprises besides bipolar transistors also n-channel and p-channel MOS transistors is called BiCMOS integrated circuit or BiCMOS IC.

A method of the kind mentioned in the opening paragraph is known from EP-A-500 233 wherein both the insulation regions of the first type and the insulation regions of the second type are silicon oxide regions obtained through local oxidation of the silicon body. The insulation regions of the first type are formed by silicon oxide regions recessed into the surface of the silicon body, while the insulation regions of the second type are silicon oxide regions projecting partly above the surface. The insulation regions of the first type extend deeper into the silicon body than do the insulation regions of the second type. The bipolar transistors are thus fully enclosed by insulating material.

Insulation regions obtained through local oxidation of the silicon body exhibit an edge of decreasing thickness in the direction of the enclosed active region, which edge is also referred to as bird's beak. The active region extends below this edge of the insulation region. When a base zone is formed in the active region in usual manner, this zone will extend also below the edge of the insulation region. The portion of the base zone lying below the edge of the insulation region in practice does not form part of the active base zone of the transistor but it does contribute to the collector-base capacitance. This contribution is comparatively great in transistors of sub-micron dimensions. As a result, these transistors are comparatively slow.

The invention has for its object inter alia to provide a method of manufacturing a semiconductor device with bipolar transistors which are faster than those in the device manufactured by the known method.

According to the invention as claimed in claim 1, the method of manufacturing a semiconductor device is for this purpose characterized in that the insulation regions of the first type are formed by etching grooves and filling said grooves with insulating material through deposition, and the insulation regions of the second type are formed by locally oxidizing the silicon body.

Insulation regions formed by etched grooves filled up with insulating material have edges which are substantially perpendicular to the surface of the silicon body. The enclosed active region terminates at said edges which are perpendicular to the surface. A base zone formed in the active region in usual manner will also terminate against this edge which is perpendicular to the surface. The base-collector capacitance of a transistor having such a base zone is thus smaller than that of a transistor having a base zone formed in an active region extending below an edge of an insulation region obtained through local oxidation of the silicon body. As a result, the transistor is faster.

When the MOS transistors are also provided in active regions enclosed by insulation regions formed by etched grooves filled with insulating material through deposition, said insulation region edge which is perpendicular to the surface may give problems in the growing of gate oxide. A gate oxide layer which is much thinner than that of the active region will then be formed on the sharp transition from the insulation region to the active region. Undesirable breakdown of the gate oxide may accordingly occur at this transition during operation of the MOS transistor. In the device according to the invention, the MOS transistors are provided in active regions surrounded by insulation regions obtained through local oxidation of the silicon body. The insulation region and the active region in that case have a less sharply angled transition, so that the gate oxide problem described above does not occur in practice.

US-A-4 884 117 discloses a circuit, which contains bipolar and MOS transistors and trenches to provide a bipolar transistor collector contact. These trenches are filled with polycrystalline silicon.

In US-A-4 746 963, both deep grooves filled with a burying material and thick oxide films produced by local oxidation of the semiconductor body are disclosed. The LOCOS field oxide films however, are not used as an isolation area between different active semiconductor areas.

US-A-4 044 452 discloses a semiconductor chip with different devices being dielectrically isolated from each other. The trenches disclosed in this document are filled with oxide through local oxidation and not through deposition.

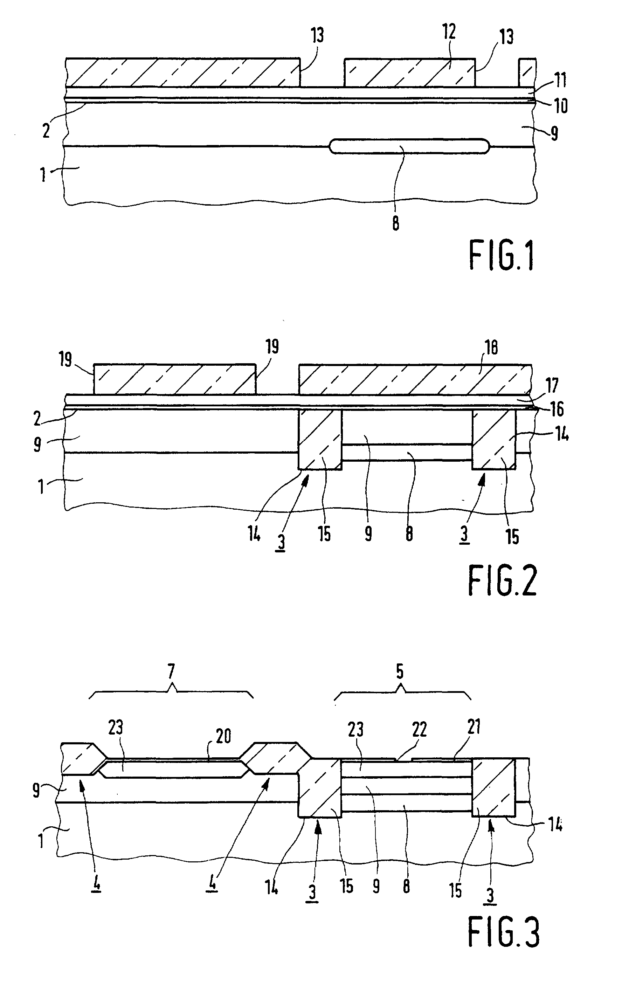

Figs. 1 to 5 diagrammatically and in cross-section show a few stages in the manufacture of a semiconductor device comprising a silicon body 1 with a surface 2 adjoined by insulation regions of a first 3 and a second type 4, the insulation regions *of* the first type 3 enclosing active regions 5 each with a bipolar transistor 6, and the insulation regions of the second type 4 enclosing active regions 7 each with an MOS transistor 8.

The present example starts with a silicon body 1 which is provided with a buried layer 8 comparatively heavily n-type doped with approximately 10¹⁸ atoms per cc and with an epitaxially grown surface layer 9 comparatively weakly doped with approximately 10¹⁶ atoms per cc at the area of the bipolar transistor 6 to be formed. An approximately 200 nm thick silicon oxide layer 10 and an approximately 100 nm thick silicon nitride layer 11 are formed on the surface 2. A photoresist mask 12 is provided thereon in usual manner and is given windows 13 at the areas of the insulation regions of the first type 3 to be formed.

Grooves 14 are etched into the silicon body by means of the photoresist mask 12, in this case cutting through the buried layer 8. The grooves 14 are subsequently filled with insulating material 15 in usual manner through the deposition of a thick silicon oxide layer, whereupon the silicon body 1 is subjected to an etching treatment until the surface 2 has become exposed. The etching treatment here stops first at the silicon nitride layer 11, which is subsequently selectively removed relative to the subjacent silicon oxide layer 10. Finally, the layer of silicon oxide 10 is also removed.

On the surface 2 and on the insulation regions of the first type 3, subsequently, an approximately 20 nm thick silicon oxide layer 16 and an approximately 200 nm thick silicon nitride layer 17 are now formed. A photoresist mask 18 is provided thereon in usual manner and is given windows 19 at the areas of the insulation regions of the second type 4 to be formed. Then the relevant windows are etched into the silicon nitride layer 17 and the silicon oxide layer 16 by means of the photoresist mask 18. The silicon body 1 is subsequently subjected to a usual oxidation treatment whereby the approximately 600 nm thick insulation regions of the second type 4 are formed. The silicon oxide layer 16 and the silicon nitride layer 17 are subsequently removed.

After the insulation regions 3 and 4 have been formed, the active regions 5 and 7 have been defined, in this example for forming therein an npn-type bipolar transistor 6 and an n-channel MOS transistor 8. The silicon body may comprise in practice both bipolar transistors of the npn-type and bipolar transistors of the pnp type, as well as MOS transistors of the n-channel type and MOS transistors of the p-channel type. A semiconductor device which comprises besides bipolar transistors also n-channel and p-channel MOS transistors is sometimes referred to as BiCMOS integrated circuit or BiCMOS IC.

An approximately 10 nm thick silicon oxide layer 20 is formed through oxidation of silicon on the active region 7 where the MOS transistor 8 is to be made, while an approximately 100 nm thick silicon oxide layer 21 is deposited on the active region 5 where the bipolar transistor 6 is planned. After deposition of an approximately 10 nm thick layer of amorphous silicon (not shown), a p-type surface layer 23 doped with approximately 10¹⁸ atoms is formed in usual manner. This layer 23 forms a p-well in the active region 7 in which the n-channel MOS transistor 8 is formed, while it forms the base zone of the bipolar transistor in the active region 5.

A window 22 is now provided in the silicon oxide layer 21 at the area of the emitter of the bipolar transistor 6 to be formed. Then tracks 24 of n-type doped polycrystalline silicon are formed on the silicon oxide layers 20 and 21, the sides 25 of said tracks 24 being insulated with strips 26 of silicon oxide. The track 24 on the active region 7 forms the gate electrode of the MOS transistor 8, the track 23 on the active region 5 forms the electrode which is connected to the emitter 27 of the bipolar transistor 6. This emitter 27 is obtained through diffusion into the p-type surface zone 23 from the track 24 through the window 22.

In usual manner, finally, an n-type doped collector contact zone 28, a p-type base contact zone 29, and an n-type source zone 30 and drain zone 31 are formed.

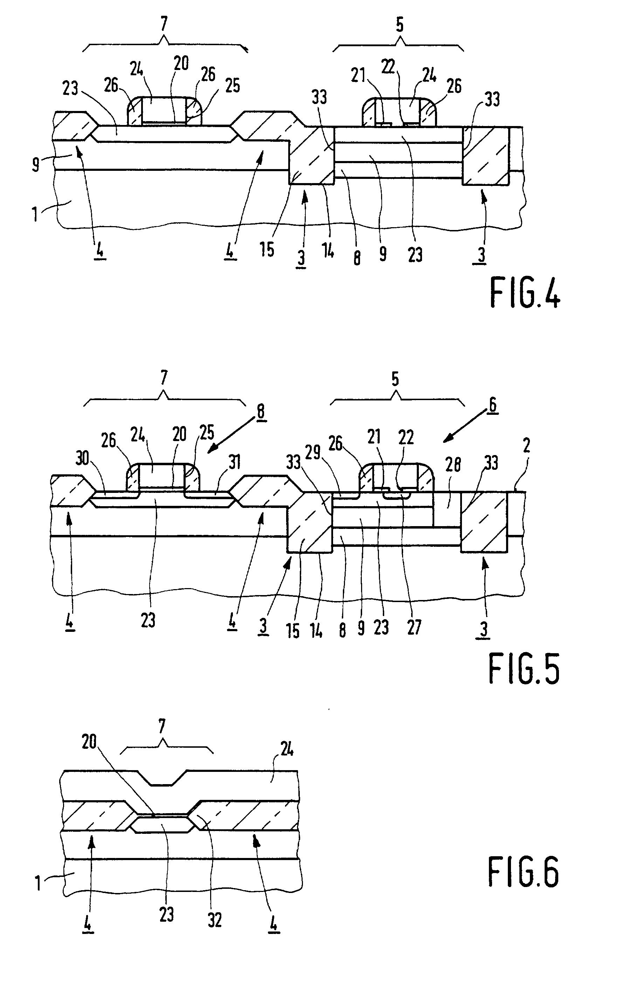

Fig. 6 diagrammatically shows a cross-section taken through the MOS transistor 8 shown in Fig. 5. The insulation regions 4 obtained through local oxidation of the silicon body exhibit an edge 32 of decreasing thickness in the direction of the enclosed active region 7, which edge is sometimes called bird's beak. The active region 7 extends below this edge 32 of the insulation region. When a semiconductor zone 23 is formed in usual manner in the active region 7, this zone will extend also below the edge 32 of the insulation region 4. If said semiconductor zone forms the base zone of a bipolar transistor, that portion thereof lying below the edge of the insulation region will not form part of the active base of the transistor in practice, but it does contribute to the collector-base capacitance. This contribution is comparatively great in the case of transistors of sub-micron dimensions. Such transistors are accordingly comparatively slow.

Insulation regions 3 formed by etched grooves 14 filled with insulating material 15 have edges 33 which are substantially perpendicular to the surface 2 of the silicon body 1. The enclosed active region 5 terminates against said edge 33 which is perpendicular to the surface. A base zone 23 formed in usual manner in the active region will also terminate at this edge 33 which is perpendicular to the surface. The base-collector capacitance of a transistor having such a base zone is thus smaller than that of the transistor having a base zone formed in an active region extending below an edge of an insulation region obtained through local oxidation of the silicon body. The transistor is faster as a result of this.

If the MOS transistor 8 is also provided in an active region enclosed by insulation regions formed by etched grooves 14 filled with insulating material 15 through deposition, said edge 33 of the insulation region which is perpendicular to the surface may give rise to problems in growing of gate oxide. A gate oxide layer which is much thinner than that on the active region will then be formed on the sharp transition between insulation region 3 and active region 5. Undesirable breakdown of the gate oxide may result therefrom at this transition during operation of the MOS transistor. In the device according to the invention, the MOS transistors are provided in active regions 7 which are enclosed by insulation regions 4 formed through local oxidation of the silicon body. The insulation region 4 and the active region 7 in that case have a less sharply angled transition, so that the problem with the gate oxide as described above will not arise in practice.

## Claims

1. A method of manufacturing a semiconductor device comprising a silicon body (1) with a surface (2) which is adjoined by insulation regions of a first (3) and a second type (4), the insulation regions of the first type (3) enclosing active regions (5) each with a bipolar transistor (6) and the insulation regions of the second type (4) enclosing active regions (7) each with an MOS transistor (8), wherein the insulation regions of the first type (3) are formed by etching grooves (14) and filling said grooves (14) with insulating material (15) through deposition, and the insulation regions of the second type (4) are formed by locally oxidizing the silicon body (1).

2. A method of manufacturing a semiconductor device as claimed in claim 1, **characterized in that** the insulation regions of the first type (3) have edges (33) which are directed perpendicularly to the surface (2).

3. A method of manufacturing a semiconductor device as claimed in claim 2, **characterized in that** the bipolar transistor (6) has a base zone (23) which is bounded by said edge (33) which is directed perpendicular to the surface (2).

## Patentansprüche

1. Verfahren zur Herstellung einer Halbleiteranordnung mit einem Siliciumkörper (1) mit einer Oberfläche (2), an die Isolationsgebiete eines ersten (3) und eines zweiten Typs (4) grenzen, wobei die Isolationsgebiete vom ersten Typ (3) jeweils aktive Gebiete (5) mit einem Bipolartransistor (6) umschließen und die Isolationsgebiete vom zweiten Typ (3) jeweils aktive Gebiete (5) mit einem MOS-Transistor (8) umschließen, wobei die Isolationsgebiete vom ersten Typ (3) durch Ätzen von Gräben (14) und Füllen dieser Gräben (14) mit isolierendem Material (15) mittels Deposition gebildet werden, und die Isolationsgebiete vom zweiten Typ (4) durch lokale Oxidation des Siliciumkörpers (1) gebildet werden.

2. Verfahren zur Herstellung einer Halbleiteranordnung nach Anspruch 1, **dadurch gekennzeichnet, dass** die Isolationsgebiete vom ersten Typ (3) senkrecht zur Oberfläche (2) gerichtete Ränder (33) aufweisen.

3. Verfahren zur Herstellung einer Halbleiteranordnung nach Anspruch 2, **dadurch gekennzeichnet, dass** der Bipolartransistor (6) eine Basiszone (23) hat, die von dem genannten, senkrecht zur Oberfläche (2) gerichteten Rand (33) begrenzt wird.

## Revendications

1. Procédé pour fabriquer un dispositif à semi-conducteur comportant un corps de silicium (1) avec une surface (2) qui est contiguë à des régions d'isolation d'un premier (3) et d'un deuxième type (4), les régions d'isolation du premier type (3) enfermant des régions actives (5) chacune ayant un transistor bipolaire (6) et les régions d'isolation du deuxième type (4) enfermant des régions actives (7) chacune ayant un transistor MOS (8), où les régions d'isolation du premier type (3) sont formées par des rainures de décapage (14) et par le remplissage desdites rainures (14) de matériau isolant (15) par dépôt, et où les régions d'isolation du deuxième type (4) sont formées par oxydation locale du corps de silicium (1).

2. Procédé pour fabriquer un dispositif à semi-conducteur selon la revendication 1, **caractérisé en ce que** les régions d'isolation du premier type (3) présentent des bords (33) qui sont dirigés perpendiculairement à la surface (2).

3. Procédé pour fabriquer un dispositif à semi-conducteur selon la revendication 2, **caractérisé en ce que** le transistor bipolaire (6) présente une zone de base (23) qui est bornée par ledit bord (33) étant dirigé perpendiculairement à la surface 2.
